# DEMANDE DE BREVET EUROPEEN

(11) **EP 1 650 795 A1**
(43) Date de publication de la demande: **26.04.2006**
(21) Numéro de dépôt: 05109643.6
(22) Date de dépôt: 17.10.2005
(51) Int. Cl.: H01L 21/762

(54) **Procédé de réalisation de multicouches sur un substrat**

(30) Priorité: 19.10.2004 FR 0411075
(71) Demandeur: COMMISSARIAT A L'ENERGIE ATOMIQUE, 75752 Paris Cédex 15 (FR)
(72) Inventeur: Tauzin, Aurélie, 38000, Grenoble (FR); Gilet, Philippe, 38210, Saint Quentin sur Isère (FR)
(74) Mandataire: Poulin, Gérard

(57) **Abrégé**

L'invention concerne un procédé de réalisation d'un multicouche sur un substrat de réception, comprenant les étapes suivantes :
- formation d'un substrat initial comportant une couche d'un premier matériau formée sur la face d'un substrat support en un deuxième matériau, le premier matériau ayant une température d'évaporation supérieure à la température d'évaporation du deuxième matériau,
- collage par adhésion moléculaire de la face du substrat initial comportant la couche de premier matériau sur la face de collage d'un substrat de réception pour obtenir une structure collée,
- élimination partielle du substrat initial de manière à laisser une couche mince dudit deuxième matériau sur la couche de premier matériau,
- évaporation de la couche mince de deuxième matériau avec arrêt sélectif sur la couche de premier matériau, l'évaporation étant effectuée à une température supérieure ou égale à la température d'évaporation du deuxième matériau, et inférieure à la température d'évaporation du premier matériau,
- croissance d'au moins une couche à partir de la couche de premier matériau collée sur le substrat de réception,
l'étape d'évaporation et l'étape de croissance étant réalisées dans un même bâti technologique.

## Description

### DOMAINE TECHNIQUE

L'invention concerne un procédé de réalisation de multicouches sur un substrat de réception. Ce procédé permet entre autres d'obtenir une structure à cavité résonante comprenant une couche active qui émet ou qui détecte de la lumière intercalée entre deux miroirs réfléchissants.

### ÉTAT DE LA TECHNIQUE ANTÉRIEURE

La réalisation de multicouches (par exemple des multicouches III-V de type GaAs) sur un substrat est généralement obtenue au moyen des étapes suivantes :
- réalisation d'un empilement de couches par croissance d'une couche d'arrêt (par exemple AlAs), puis d'une couche active (par exemple GaAs) sur un substrat support (par exemple GaAs),
- implantation d'espèces gazeuses tels que H, He, des gaz rares... dans le substrat support,
- collage par adhésion moléculaire de l'empilement sur un substrat de réception (par exemple en silicium) pour obtenir une structure collée,
- fracture du substrat support au niveau de la zone implantée, ladite fracture étant provoquée par un traitement thermique et/ou l'application de contraintes mécaniques sur la structure implantée collée ; on obtient ainsi, d'une part le substrat support (qui va pouvoir être réutilisé), prélevé d'un film mince, d'autre part le substrat de réception sur lequel sont reportés la couche active, la couche d'arrêt et le film mince prélevé du substrat support,
- gravures sélectives du film mince prélevé du substrat support et de la couche d'arrêt,
- croissance de multicouches (par exemple III-V) à partir de la couche active reportée sur le substrat de réception ; la croissance peut se faire par épitaxie, par exemple.

Selon les applications, les multicouches réalisées sur la couche active disposée sur le substrat de réception pourront ensuite subir différentes étapes technologiques relatives à la fabrication de divers dispositifs, par exemple des cellules photovoltaïques.

Dans cette suite d'étapes, c'est l'étape des gravures sélectives qui pose problème. En effet, pour pouvoir obtenir des multicouches de bonne qualité, compatibles avec l'application visée, il faut que le film mince et la couche d'arrêt soient intégralement gravés sans que la couche active en soit affectée. De plus, si l'on veut que la couche active soit compatible avec une croissance par épitaxie, il faut que la surface de la couche active soit lisse et propre, de faible rugosité, sans défauts cristallographiques ni impuretés.

D'après le document **[1]**, l'étape de gravures sélectives peut se faire par attaque chimique. Pour cela, on utilise tout d'abord une solution qui va graver le film mince sélectivement par rapport à la couche d'arrêt, puis une solution qui va graver la couche d'arrêt sélectivement par rapport à la couche active. Le choix de l'attaque chimique pour réaliser les gravures sélectives présente des inconvénients. En effet, ce choix nécessite l'utilisation de deux solutions chimiques différentes, spécifiques à la nature des couches à enlever/préserver. D'autre part, la gravure sélective par attaque chimique peut induire des défauts dans la couche active et/ou modifier sa surface (par exemple sa rugosité,...).

Par ailleurs, le fait de graver le film mince met à nu la couche d'arrêt. Or, la couche d'arrêt, selon sa composition, peut se détériorer au contact de l'air (par exemple, si la couche d'arrêt est en AlAs). Dans ce cas, on devra enlever cette couche d'oxydation par une étape de gravure supplémentaire qui complexifie le procédé de réalisation des multicouches.

### EXPOSÉ DE L'INVENTION

Nous proposons une approche originale pour la réalisation de multicouches sur un substrat de réception, cette approche ne comportant pas les inconvénients présentés précédemment.

L'invention concerne un procédé de réalisation d'un multicouche sur un substrat de réception, ledit procédé comprenant les étapes suivantes :
- formation d'un substrat initial comportant une couche d'un premier matériau formée sur la face d'un substrat support en un deuxième matériau, le premier matériau ayant une température d'évaporation supérieure à la température d'évaporation du deuxième matériau,
- collage par adhésion moléculaire de la face du substrat initial comportant la couche de premier matériau sur la face de collage d'un substrat de réception pour obtenir une structure collée,
- élimination partielle du substrat initial de manière à laisser une couche mince dudit deuxième matériau sur la couche de premier matériau,
- évaporation de la couche mince de deuxième matériau avec arrêt sélectif sur la couche de premier matériau, l'évaporation étant effectuée à une température supérieure ou égale à la température d'évaporation du deuxième matériau, et inférieure à la température d'évaporation du premier matériau,
- croissance d'au moins une couche à partir de la couche de premier matériau collée sur le substrat de réception,
   l'étape d'évaporation et l'étape de croissance étant réalisées dans un même bâti technologique. En d'autres termes, la croissance et l'évaporation sont réalisées dans le même bâti technologique, c'est-à-dire sans remise à l'air intermédiaire. Par température d'évaporation d'un matériau, on entend la température à partir de laquelle sa vitesse d'évaporation devient significative (typiquement de l'ordre de quelques nanomètres par minute).

Avantageusement, le substrat support en deuxième matériau est un substrat de deuxième matériau ou une couche de deuxième matériau formée sur un substrat déterminé.

Avantageusement, le procédé comprend en outre, avant l'étape de collage, une étape de formation d'au moins une couche supplémentaire sur la couche de premier matériau. Cette au moins une couche supplémentaire pourra servir entre autre à protéger la couche de premier matériau. Ce pourra également être une couche de collage (par exemple en SiO₂).

Avantageusement, le substrat de réception comporte en outre au moins une couche sur sa face de collage, par exemple en SiO₂.

Avantageusement, la face du substrat support en deuxième matériau comportant la couche de premier matériau et/ou la face de collage du substrat de réception comporte(nt) en outre un miroir de Bragg constitué d'une alternance de couches minces d'indice de réfraction n₁ et d'indice de réfraction n₂ différents.

Selon un mode de réalisation particulier, l'étape d'élimination partielle du substrat initial est réalisée en effectuant, préalablement à l'étape de collage, une implantation d'espèces gazeuses dans le substrat support de deuxième matériau, et en effectuant un recuit thermique de la structure implantée collée obtenue, à une température inférieure à la température d'évaporation du deuxième matériau et/ou en appliquant des contraintes mécaniques à la structure implantée collée. On obtient ainsi, d'une part le substrat support, qui peut être recyclable, prélevé d'une couche mince, et d'autre part, le substrat de réception sur lequel sont reportées la couche mince prélevée du substrat support, ainsi que la couche de premier matériau.

Avantageusement, les espèces gazeuses utilisées pour l'implantation sont des ions H ou He, des gaz rares.

Selon un autre mode de réalisation particulier, l'étape d'élimination partielle du substrat initial est réalisée par un amincissement mécano-chimique dudit substrat initial jusqu'à obtenir une couche mince de deuxième matériau sur la couche de premier matériau.

Avantageusement, l'étape de croissance de ladite au moins une couche sur la couche de premier matériau est réalisée par épitaxie par jets moléculaires (« MBE » en anglais) ou par dépôt en phase vapeur de composés précurseurs organométalliques (« MOCVD » en anglais), ou par dépôt en phase vapeur assisté par plasma (« PECVD » en anglais). D'autres types de dépôt pourraient être réalisés (pulvérisation cathodique, dépôt par faisceaux d'électrons, IBS (« Ion Beam Sputtering » en anglais...).

Avantageusement, le premier matériau est en AlAs, Si...

Avantageusement, le deuxième matériau est en GaAs, SiₓGe₁₋ₓ, InP, Ge...

Avantageusement, le substrat de réception est en un matériau choisi parmi le silicium, le verre et la céramique, ou tout autre support adéquat pour l'application visée.

Avantageusement, la au moins une couche formée sur la couche de premier matériau collée est en un matériau choisi parmi GaAs, AlAs, Si, SiGe ou SiO₂... On peut ainsi obtenir une bicouche de type III-V.

L'invention permet également d'obtenir des structures à cavité résonante. L'invention concerne ainsi une structure à cavité résonante comprenant une couche active, qui émet ou qui détecte de la lumière, intercalée entre deux miroirs réfléchissants, ladite structure étant réalisée à partir du procédé de réalisation selon le procédé de réalisation de l'invention.

Avantageusement, les deux miroirs réfléchissants sont des miroirs de Bragg obtenus à partir de couches minces dont les matériaux sont choisis parmi Si₃N₄, SiO₂, TiO₂, Si ou HfO₂.

Le procédé de réalisation de multicouches selon l'invention présente de nombreux avantages.

Tout d'abord, l'étape d'évaporation du film mince et l'étape de croissance de la au moins une couche sur la couche de premier matériau sont réalisées dans le même bâti. L'utilisation d'un même bâti pour ces deux étapes limite le nombre d'équipements nécessaires et donc les coûts. Elle minimise les manipulations et les transports de plaques, limitant les risques d'endommagement.

La structure constituée du substrat de réception, de la couche de premier matériau et de la couche mince de deuxième matériau peut par ailleurs être considérée comme étant « épi ready », au sens où cette structure n'a pas besoin de subir une préparation chimique de sa surface avant d'être introduite dans le réacteur ou bâti d'épitaxie : l'élimination de la couche mince de deuxième matériau se fait par une étape thermique avant l'étape de croissance par épitaxie.

La face de la couche de premier matériau sur laquelle on réalise la croissance d'au moins une couche est protégée (car elle est enterrée) tout au long du procédé. Elle ne subit donc aucune altération, physique ou chimique, ce qui est favorable à la croissance de multicouches de bonne qualité.

Contrairement à l'art antérieur, la couche de premier matériau, qui correspond à la couche d'arrêt de l'art antérieur, n'est pas en contact de l'air : elle reste sous atmosphère contrôlée. Elle ne se détériore donc pas. Ainsi, il n'est pas nécessaire de l'enlever pour réaliser la croissance des multicouches : on simplifie donc le procédé.

La au moins une couche formée sur la couche de premier matériau collée peut être obtenue quel que soit le procédé de croissance utilisé : elle peut être obtenue par croissance par épitaxie par jets moléculaires ou par dépôt en phase vapeur de composés précurseurs organométalliques (« MOCVD » en anglais) ou encore par PECVD. L'épaisseur de cette couche (ou de ces couches) est donc parfaitement maîtrisée et, plus généralement, l'épaisseur de tout l'empilement réalisé à partir de cette couche. En effet, aucune étape de gravure chimique ni de polissage n'est effectuée, ces étapes étant par nature moins précises que les étapes d'épitaxie ou de dépôt.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1F illustrent les étapes de réalisation d'un multicouche sur un substrat selon l'invention,
- les figures 2A à 2E illustrent les étapes de réalisation d'un autre multicouche sur un substrat selon l'invention,
- les figures 3A à 3E illustrent les étapes de réalisation d'un multicouche comprenant un miroir de Bragg selon l'invention,
- les figures 4A à 4E illustrent les étapes d'un autre exemple de réalisation d'un multicouche comprenant un miroir de Bragg selon l'invention.

Il faut noter que les dimensions des couches et des substrats dans ces figures ne sont pas représentées à l'échelle.

### EXPOSÉ DÉTAILLÉ DE MODES DE RÉALISATION PARTICULIERS

Dans un premier exemple de réalisation, nous allons détailler les étapes de réalisation d'un multicouche GaInP/GaAs/AlAs/GaAs/Si₃N₄/SiO₂ sur un substrat de réception Si.

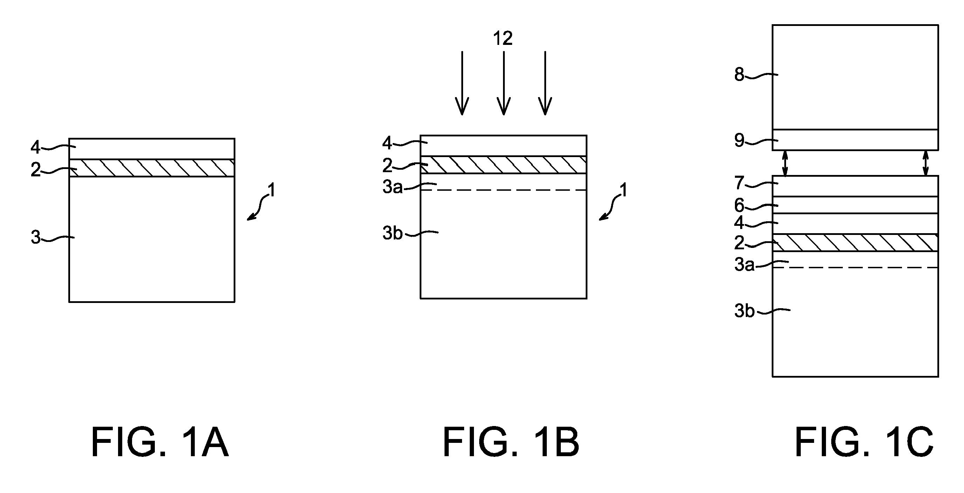

On forme tout d'abord un substrat initial 1 comprenant un substrat support 3 de GaAs sur lequel on fait croître, par exemple par épitaxie à jets moléculaires, une couche de premier matériau 2 en AlAs d'épaisseur 100 nm, puis une couche supplémentaire 4 en GaAs d'épaisseur 150 nm sur la couche de premier matériau (figure 1A). Le mode opératoire pour réaliser par épitaxie par jets moléculaires une couche de matériau d'épaisseur déterminée est bien connu de l'homme du métier. On aurait également pu déposer ces couches par dépôt par MOCVD.

Pour réaliser l'étape d'élimination partielle du substrat initial 1, on décide d'utiliser la méthode Smart Cut, c'est-à-dire une implantation d'espèces gazeuses, suivie par exemple d'un recuit thermique, qui produit une fracture au niveau de la zone implantée. On effectue donc une implantation 12 d'espèces gazeuses dans le substrat support 3 GaAs (sur la face comprenant la couche de premier matériau 2). Le substrat support 3 est alors séparé en deux parties 3a et 3b de part et d'autre de la zone implantée (figure 1B).

L'énergie d'implantation doit être suffisamment élevée pour que la zone implantée soit située dans le substrat support 3 GaAs : la profondeur d'implantation doit être supérieure à l'épaisseur de l'empilement formé par la couche de premier matériau 2 en AlAs et le couche supplémentaire 4 en GaAs. Typiquement, si cet empilement a une épaisseur de l'ordre de 250 nm, on pourra choisir une énergie de l'ordre de 100 KeV.

D'autre part, la dose d'ions doit être suffisante pour qu'une fracture se propage au niveau de la zone implantée, sous activation thermique et/ou sous l'application de contraintes mécaniques. La dose d'ions ne doit cependant pas dépasser la dose critique au-delà de laquelle on observe le cloquage du substrat support 3 implanté. Typiquement, on utilise des ions H⁺ et la dose implantée est comprise entre 6,10¹⁶ H⁺/cm² et 1,10¹⁷ H⁺/cm².

La température d'implantation est un paramètre critique qui détermine l'obtention ou non d'une fracture au niveau de la zone implantée, sous activation thermique, avec éventuellement l'application de contraintes mécaniques. Contrairement au cas du Si ou du SiC, la température d'implantation du GaAs doit être comprise dans une fenêtre très étroite (entre 160°C et 250°C) .

Une fois l'implantation terminée, on réalise le collage par adhésion moléculaire de la face du substrat initial 1 comportant ici à sa surface la couche supplémentaire 4 en GaAs sur la face de collage d'un substrat de réception 8 qui va servir de raidisseur. En effet, le procédé Smart Cut peut nécessiter le collage de la couche à transférer sur un raidisseur 8 (par exemple un substrat de silicium), pour permettre le phénomène de fracture pleine plaque. Dans le cas présenté, le substrat de réception 8 est en silicium. Le collage par adhérence moléculaire de la couche supplémentaire 4 en GaAs sur le substrat de silicium peut être obtenu en effectuant un nettoyage chimique de la surface de la couche 4 en GaAs, suivi d'un dépôt d'une couche 6 de Si₃N₄ de 100 nm d'épaisseur sur la couche de GaAs et d'une couche 7 de SiO₂ également de 100 nm d'épaisseur. Puis, on réalise un polissage mécano-chimique de la surface de la couche de SiO₂ et on la met en contact avec une couche 9 de SiO₂ de 200 nm d'épaisseur disposée sur le substrat de réception 8 en silicium. La couche 9 de SiO₂ du substrat de réception 8 en silicium peut également subir un polissage mécano-chimique pour faciliter le collage par adhésion moléculaire. On obtient ainsi une structure collée formée d'un empilement comprenant le substrat support 3 en deuxième matériau, la couche de premier matériau 2, la couche supplémentaire 4, la couche Si₃N₄ 6, la couche SiO₂ 7, la couche SiO₂ 9 et le substrat de réception 8 (figure 1C).

On réalise ensuite la fracture du substrat initial 1 au niveau au niveau de la zone implantée se situant dans le substrat support 3 en GaAs. Cette fracture ne pourra s'effectuer que si le substrat de réception 8 collé joue son rôle de raidisseur.

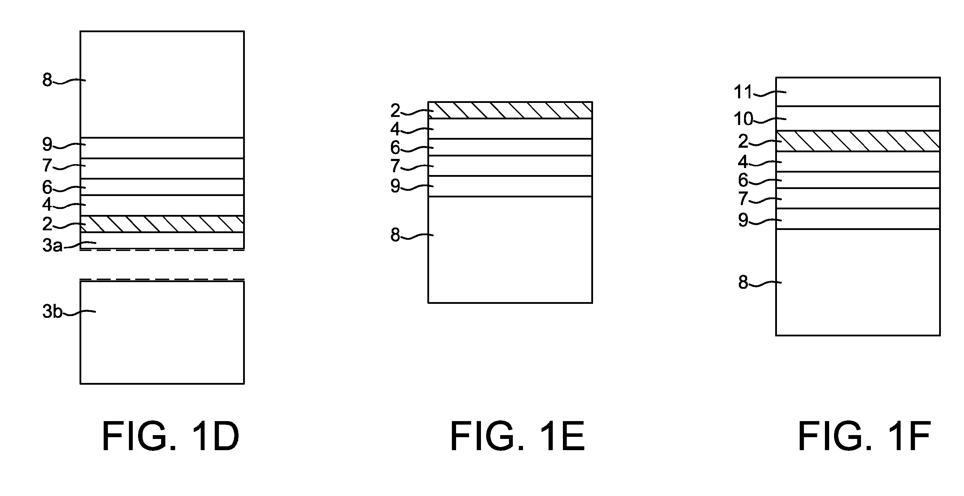

La fracture peut alors être obtenue par exemple en effectuant le recuit de la structure collée. La température du recuit est choisie de manière à ce qu'on obtienne une fracture au niveau de la zone implantée, mais également pour renforcer le collage par adhésion moléculaire. Typiquement, le collage peut être réalisé, par exemple, à température ambiante, le recuit pour la consolidation du collage peut être réalisé à 150°C et la fracture peut être obtenue à 250°C. En particulier, il est nécessaire de tenir compte de la compatibilité mécanique entre les deux matériaux des substrats (le substrat initial et le substrat de réception) qui imposent leurs courbures aux couches minces qu'ils supportent. Par exemple, il faut tenir compte de leurs coefficients de dilatation, d'élasticité..., pour éviter la rupture des plaques et/ou la formation de dislocations lors de la montée en température de la structure collée. De plus, pour que la fracture se produise, il faut que les microcavités créées par l'implantation dans le substrat support 3 en GaAs aient le temps de croître pour fragiliser le matériau. La fracture du substrat support GaAs peut être obtenue par exemple par un recuit RTA (« rapid thermal anneling » en anglais) à 250°C de la structure collée, en combinaison ou non avec l'application de contraintes mécaniques (par exemple par insertion d'une lame entre les deux substrats). La fracture donne lieu au transfert des couches GaAs/AlAs/GaAs/Si₃N₄/SiO₂ sur le substrat de réception en silicium, le reste du substrat support 3b de GaAs pouvant alors être recyclé et réutilisé ultérieurement (voir la figure 1D).

Dans un bâti, la couche mince 3a de GaAs peut ensuite être éliminée par évaporation à environ 650°C sous un flux d'arsenic, avec un arrêt sélectif sur la couche de premier matériau 2 en AlAs (figure 1E). La couche d'AlAs peut alors dans ce même bâti servir au départ de croissance d'une ou plusieurs couches de matériau comme GaAs, GaAlAs, GaInP, GaAsN ou tout autre couche dont le paramètre de maille est proche de celui de AlAs. Il est important de noter que cette couche de premier matériau 2 en AlAs n'aura jamais vu l'air, ce qui évite toute pollution et surtout toute oxydation de sa surface.

Ainsi, on peut faire croître une ou plusieurs couches à partir de la couche de premier matériau en AlAs mise à jour par l'étape d'évaporation. Dans l'exemple illustré dans la figure 1F, on fait croître une couche 10 de GaAs, puis une couche 11 de GaInP sur la couche d'AlAs afin de réaliser par exemple des cellules solaires. L'épitaxie peut démarrer directement par une couche de GaAs à 600°C dans un bâti d'épitaxie par jets moléculaires ou à 650-700°C pour un bâti de MOCVD, l'étape d'évaporation ayant été réalisée précédemment dans ce même bâti. On peut ensuite faire croître une couche de GaInP sur la couche de GaAs.

Le GaAs est un bon candidat pour constituer la couche mince de deuxième matériau (provenant du substrat support de deuxième matériau) et l'AlAs pour la couche de premier matériau. En effet, GaAs et AlAs ont des températures d'évaporation très distinctes. Le GaAs s'évapore de façon significative à partir de 650°C et l'AlAs au-delà de 700°C. Avantageusement, l'évaporation de la couche mince de deuxième matériau est réalisée sous une contre pression d'arsenic pour éviter la dégradation du premier matériau. Ainsi, en évaporant le GaAs (de préférence sous flux d'arsenic) à une température supérieure ou égale à 650°C mais inférieure à 700°C, il est possible de supprimer entièrement la couche mince de deuxième matériau et de ne pas entamer la couche de premier matériau, c'est-à-dire de s'arrêter sélectivement sur la couche d'AlAs.

Selon un autre exemple, nous allons réaliser un multicouche film mince/Si/SiO₂ sur un substrat de silicium avec un film du silicium qui peut être très mince (inférieur ou égal à 5 nm).

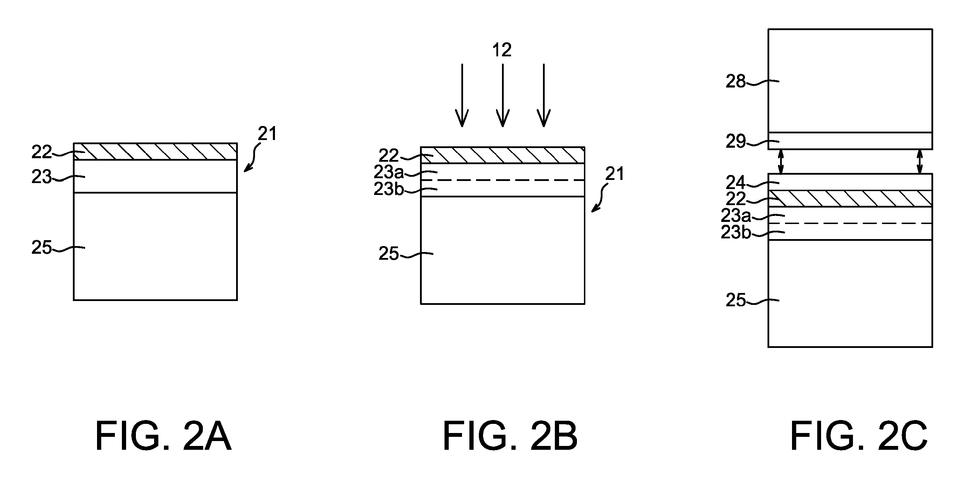

On prépare tout d'abord un substrat initial 21 en faisant croître une couche 23 de Si_{0,7}Ge_{0,3} d'épaisseur 1 µm sur un substrat 25 de silicium, puis on forme une couche 22 de Si d'épaisseur 5 nm sur la couche de Si_{0,7}Ge_{0,3} (figure 2A). Ici, la couche de premier matériau 22 en Si est déposé sur un substrat support consistant en une couche de deuxième matériau 23 en Si_{0,7}Ge_{0,3} déposée sur une substrat déterminé 25 en Si.

Dans cet exemple, on prévoit de réaliser l'étape d'élimination partielle du substrat initial en utilisant le procédé Smart Cut afin d'obtenir une couche mince 23a de deuxième matériau Si_{0,7}Ge_{0,3}. On implante donc des ions légers 12 dans la couche 23 de Si_{0,7}Ge_{0,3} (figure 2B). Par exemple, on peut implanter des ions H⁺ à une énergie de 4OKeV et à une dose de 5.10¹⁶ à 1.10¹⁷ H⁺/cm².

On réalise ensuite un collage par adhésion moléculaire du substrat initial 21 sur un substrat de réception 28 en silicium, par exemple selon les étapes suivantes (figure 2C):
- dépôt d'une couche 24 de SiO₂ sur la couche de premier matériau 22 Si du substrat initial,
- polissage mécano-chimique de cette couche 24 de SiO₂,
- mise en contact de cette couche 24 de SiO₂ avec le substrat de réception en silicium comportant une couche 29 de SiO₂ sur sa surface de collage.

Avantageusement, le collage de la couche 24 de SiO₂ avec le substrat de réception peut être consolidé par un traitement thermique à 200°C.

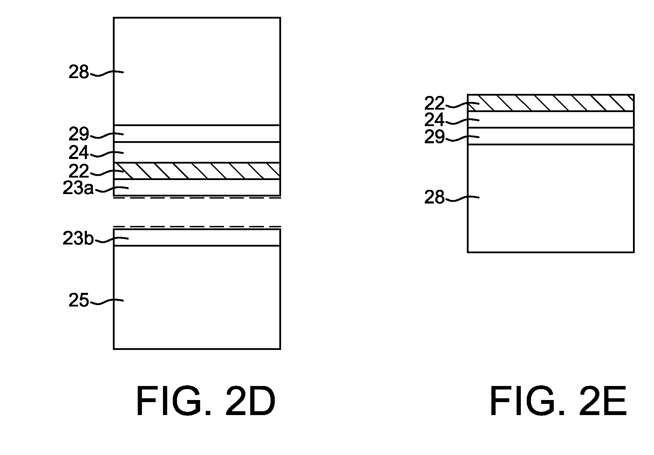

On effectue ensuite la fracture de la structure collée au niveau de la zone implantée, par exemple en effectuant un recuit à 500°C, en combinaison ou non avec l'application de contraintes mécaniques (par exemple par l'insertion d'une lame entre le substrat initial et le substrat de réception) (figure 2D). La fracture donne lieu au transfert des couches Si_{0,7}Ge_{0,3}/Si/SiO₂ sur le substrat de réception, le reste du substrat initial comportant le substrat déterminé 25 de Si et la couche 23b restante de Si_{0,7}Ge_{0,3} pouvant alors être recyclé.

Selon la figure 2E, on procède ensuite à l'évaporation de la couche mince de deuxième matériau 23a en Si_{0,7}Ge_{0,3} avec arrêt sélectif sur la couche de premier matériau 22 en Si. On obtient ainsi un substrat SOI ultra-mince (SOI ou « Silicon on Insulator » signifiant en français « silicium sur isolant »). Il est important de noter qu'en procédant ainsi, on a un contrôle parfait de l'épaisseur du film Si du dispositif SOI car son épaisseur résulte d'une étape d'épitaxie et non d'une étape de polissage ou d'attaque chimique.

On peut alors faire croître une ou plusieurs couches sur la couche 22 de Si exposée, par exemple une couche de silicium dopé de SiGe, un oxyde, un nitrure, un diélectrique ou autre selon l'application visée, l'évaporation ayant été réalisée dans le même bâti que celui servant à la croissance de cette ou ces couches.

Nous allons à présent détailler deux modes de réalisation d'un multicouche obtenu selon le procédé de l'invention et présentant un miroir de Bragg.

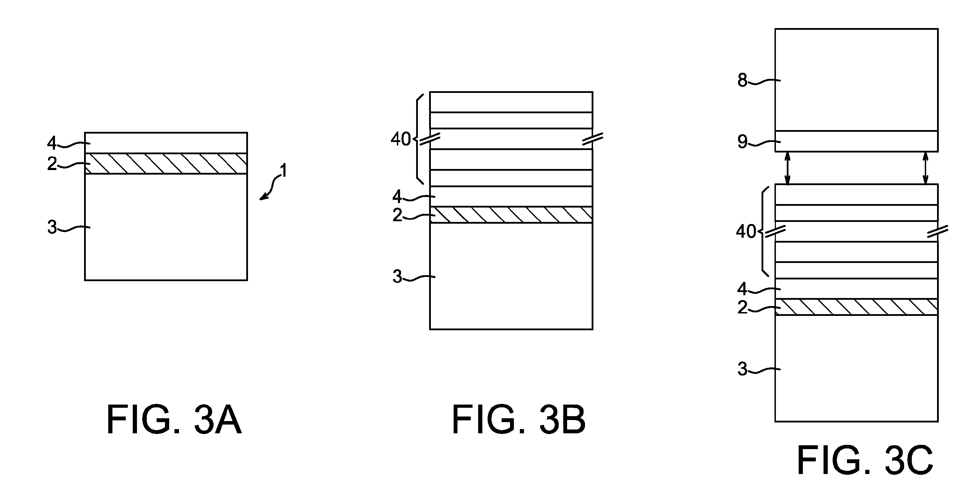

On réalise un substrat initial 1 comportant un substrat support en deuxième matériau 3, par exemple en GaAs, sur lequel est formée une couche de premier matériau 2 en AlAs de 10 nm d'épaisseur, sur laquelle on dépose ensuite une couche supplémentaire 4 de GaAs de 150 nm d'épaisseur (figure 3A).

On réalise ensuite un miroir de Bragg 40 sur le substrat initial 1 en déposant sur la couche supplémentaire 4 de GaAs un empilement alterné de couches minces d'indices de réfraction n₁ et n₂, n₁ et n₂ étant différents (figure 3B). On peut ainsi utiliser les couples de matériaux suivants : Si₃N₄/SiO₂, TiO₂/SiO₂, Si/SiO₂ ou HfO₂/SiO₂ pour réaliser un miroir de Bragg. Dans cet exemple, on dépose 20 couches Si₃N₄ et SiO₂, Si₃N₄ et SiO₂ ayant des épaisseurs respectives de 162,5 nm et de 221,7 nm pour réaliser un miroir dont la réflectivité maximum est obtenue à 1300 nm. C'est une couche de Si₃N₄ qui est déposée en premier sur la couche supplémentaire en GaAs.

On effectue ensuite le collage de la structure comprenant le miroir de Bragg avec un substrat de réception. Par exemple, on peut effectuer le collage par adhérence moléculaire oxyde/oxyde en utilisant un substrat de réception 8 en silicium sur lequel on aura déposé au préalable une couche 9 de SiO₂. Cette couche 9 en SiO₂ va ainsi adhérée à la couche de SiO₂ du miroir de Bragg 40 (figure 3C).

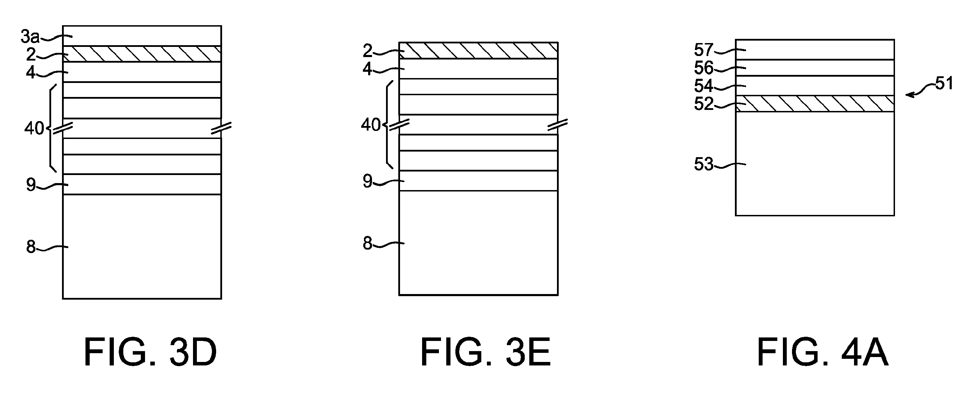

On procède ensuite à l'élimination partielle du substrat support 3 en GaAs de manière à laisser une fine couche 3a de GaAs sur la structure collée (figure 3D). Le retrait (non complet) du substrat de GaAs se fait soit par procédé Smart Cut (dans ce cas, il faut avoir préalablement implanté des espèces gazeuses dans le substrat support 3 et ensuite effectuer par exemple un recuit thermique de la structure collée pour fracturer la structure au niveau de la zone implantée), soit par amincissement du substrat support 3, par exemple par polissage mécano-chimique. Le procédé Smart Cut a l'avantage de laisser un substrat support recyclable et réutilisable ultérieurement.

La fine couche 3a de GaAs conservée sur la structure collée est ensuite évaporée dans un bâti d'épitaxie (figure 3E) et on peut alors procéder à l'épitaxie d'au moins un couche active sur la couche 2 d'AlAs mise à jour. La précision sur l'épaisseur des couches actives épitaxiées est ainsi inférieures à 1% (elle est limitée uniquement à la résolution de l'épitaxie).

L'exemple de réalisation a été donné avec du GaAs comme deuxième matériau. Il peut être étendu à d'autres substrats tels que l'InP, le Germanium... Dans l'exemple ci-dessus, le miroir de Bragg est déposé sur le substrat initial 1 sur la couche supplémentaire 4 en GaAs. Le miroir de Bragg aurait également pu être déposé sur un substrat de réception et non sur le substrat initial, comme on va le voir dans l'exemple suivant.

Nous allons présenter une autre manière de réaliser le multicouche précédent.

Selon la figure 4A, on prépare un substrat initial 51 en déposant une couche d'arrêt AlAs (couche de premier matériau 52) de 3 nm d'épaisseur sur un substrat support 53 en GaAs. On dépose également une couche supplémentaire 54 en GaAs de 150 nm d'épaisseur sur la couche de premier matériau 52 : la couche 52 en AlAs est ainsi protégée par la couche supplémentaire 54 en GaAs. On dépose également une couche 56 de Si₃N₄ et une couche 57 de SiO₂ sur la couche supplémentaire 54 de GaAs (ces deux couches 56, 57 rajoutées vont permettre le collage ultérieur du substrat initial avec le miroir de Bragg disposé sur le substrat de réception).

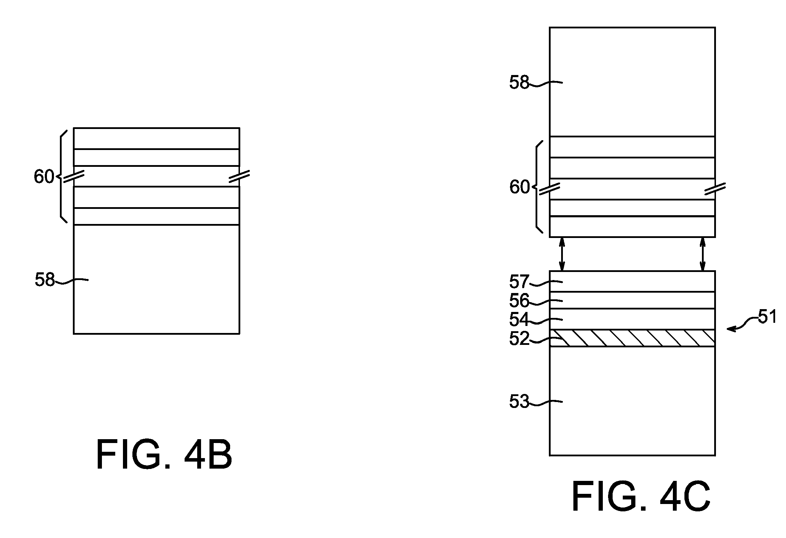

Sur un substrat de réception 58 en silicium par exemple (ou en verre, en céramique...), on réalise un miroir de Bragg 60 en déposant diélectriquement des couches minces d'indices de réfraction différents (figure 4B). Dans cet exemple, le miroir de Bragg est le même que dans l'exemple précédent. Ici, c'est une couche de SiO₂ qui est déposée en premier sur le substrat de réception en Si.

Le miroir de Bragg 60 sur son substrat 58 en silicium est ensuite collé au substrat initial 51 (figure 4C) par adhésion moléculaire. On peut procéder par exemple au collage par adhérence moléculaire oxyde/oxyde de la couche 57 de SiO₂ du substrat initial et d'un couche de SiO₂ prévue sur le miroir de Bragg 60 et n'introduisant pas de déphasage (l'épaisseur est égale à λ/2). On précise que le miroir finit par une couche de Si₃N₄ car on a commencé l'empilement par une couche de SiO₂.

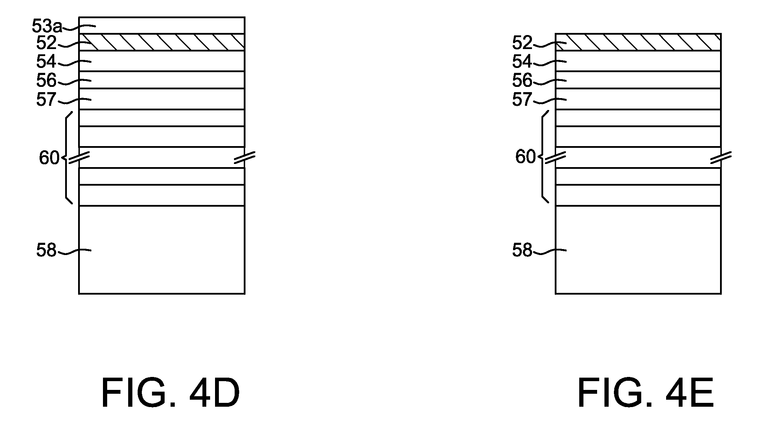

Comme dans l'exemple précédent, le retrait (non complet) du substrat support 53 de GaAs est réalisé par amincissement du substrat support jusqu'à obtenir une structure collée ayant une couche mince 53a de GaAs à sa surface (figure 4D).

Lorsqu'on est prêt à réaliser l'épitaxie, on place la structure collée dans le bâti d'épitaxie et on évapore la couche mince 53a de GaAs (figure 4E).

Enfin, on effectue la croissance par épitaxie d'au moins une couche (couche active) sur la couche de premier matériau 52 d'AlAs.

Ces deux derniers exemples présentant un miroir de Bragg 40, 60 vont permettre de réaliser des structures dites à cavité résonante. Le principe des structures dites à cavité résonante consiste à intercaler une couche active qui émet ou qui détecte de la lumière entre deux miroirs réfléchissants ou miroirs de Bragg. La réflectivité des miroirs utilisés est en général relativement importante (>95%). Parmi les exemples courants de structures à cavité résonante, on peut citer les lasers à cavité verticale (VCSEL) ou les photodétecteurs en cavité résonnante.

Généralement, la couche active est réalisée par épitaxie d'un matériau actif sur un support monocristallin. Le problème réside surtout dans le fait que le support monocristallin est ici le miroir inférieur qui est de façon courante lui même épitaxié sur un substrat. Or, compte tenu de la réflectivité désirée des miroirs (>95%), il est nécessaire de réaliser des miroirs de Bragg dits « quart d'onde », où les couches semi-conductrices formant le miroir ont une épaisseur optique quatre fois plus petite que la longueur d'onde à laquelle le miroir doit réfléchir la lumière. Les couches formant le miroir de Bragg doivent donc avoir des épaisseurs très précises. Par ailleurs, pour obtenir une réflectivité élevée et compte tenu des faibles différences d'indices observés entre les matériaux couramment utilisés et compatibles entre eux (par exemple 2,9 pour AlAs et 3,5 pour GaAs à 1,3 micromètres), le nombre d'alternance n est généralement important (supérieur à 20). On rappelle qu'un miroir de Bragg est formé d'un nombre n de bicouches d'indice n₁ et n₂ différents. Ce grand nombre d'alternances est pénalisant et nécessite la maîtrise parfaite de l'épitaxie.

De plus, pour que la structure à cavité résonante soit de bonne qualité, il est important que la précision en épaisseur des couches, notamment celles proches de la cavité, soit précise : cette précision doit être de l'ordre du pourcent.

Le procédé selon l'invention permet de s'affranchir de la croissance par épitaxie d'un miroir de Bragg inférieur, croissance difficile et contraignante.

D'autre part, certains matériaux, comme par exemple InP, ne permettent pas de faire croître par épitaxie des matériaux formant des miroirs de Bragg efficaces. Il faut alors rapporter par des techniques de collage des miroirs fabriqués ailleurs pour profiter des avantages des différents matériaux. Or, pour être efficace, la couche active, qui est généralement d'environ 1 micromètre d'épaisseur, doit se trouver au plus près des miroirs de Bragg. L'étape de collage, en particulier de la couche active, doit donc être parfaitement maîtrisée et est très difficile.

En utilisant le procédé selon l'invention, on évite ces inconvénients car le collage est réalisé avant l'épitaxie du matériau actif. Grâce à ce procédé, on peut espérer obtenir une précision sur l'épaisseur des couches compatible avec les exigences des composants (c'est à dire de l'ordre du pourcent).

De préférence, pour former le miroir inférieur ou supérieur, on utilise des matériaux diélectriques (par exemple Si/SiO₂) car cela permet de diminuer le nombre n d'alternances nécessaires pour obtenir un miroir de Bragg ayant une forte réflectivité. Par exemple, pour obtenir une même réflectivité, on peut former un miroir de Bragg à partir de 5 bicouches Si/SiO₂ au lieu de 25 pour les bicouches GaAs/AlAs. Cela est dû au fait que le système Si/SiO₂ présente une plus forte différence d'indice entre ces composants.

Nous allons à présent détailler la réalisation d'une structure à cavité résonante comprenant une couche active comprise entre un miroir de Bragg inférieur et un miroir de Bragg supérieur en Si₃N₄/SiO₂. Cette couche active peut être constituée d'un empilement de type GaAs/GaInAsN ou d'alliage comprenant Ga, In, N, Al, As, P, Sb.

En suivant les étapes illustrées dans les figures 3A-3D (ou 4A-4D), on obtient une structure collée comportant un substrat de réception 8 en Si (servant de support mécanique) présentant un empilement comprenant une couche 9 de silice, un miroir de Bragg 40 constitué d'une alternance de bicouches Si₃N_{4/}SiO₂, une couche 4 de GaAs (couche supplémentaire), une couche 2 d'AlAs (couche d'arrêt en premier matériau) et une couche mince 3a en GaAs (couche de deuxième matériau). Cette structure collée est placée dans un bâti d'épitaxie et on fait évaporer la couche mince 3a de GaAs (figure 3E). La couche d'arrêt 2 d'AlAs est ainsi mise à nue et on peut commencer l'épitaxie sur cette couche. Ici, l'épitaxie d'une ou plusieurs couches actives sur la couche 2 d'AlAs est réalisée au dessus d'un miroir de Bragg avec un parfait contrôle des épaisseurs. Le contrôle est réalisé par l'intermédiaire de la couche en AlAs qui a une température d'évaporation supérieure à la couche de deuxième matériau, dans cet exemple en GaAs.

Une fois la cavité réalisée grâce au dépôt de la couche active, il ne reste plus qu'à déposer le miroir diélectrique supérieur comprenant des bicouches Si₃N₄/SiO₂, par exemple par PECVD. La couche active peut être constituée par exemple d'un empilement GaAs/GaInNAs.

Pour les deux miroirs, il est préférable qu'ils soient de type diélectrique (Si/SiO₂, HfO₂/SiO₂, TiO₂/SiO₂...). Les deux miroirs ne sont pas obligatoirement identiques.

On procède ensuite au procédé technologique. On pourra se référer au document **[2]** pour obtenir plus de détails sur ce procédé.

### BIBLIOGRAPHIE

**[1]** K.D. Hobart et al., "Ultra-cut: A simple technique for the fabrication of SOI substrates with ultra-thin (<5nm) silicon films", Proceedings, 1998 IEEE International SOI Conference, Oct. 1998.
**[2]** "Vertical-Cavity Surface-Emitting Lasers", edited by Carl Wilmsen, Henryk Temkin and Larry A. Coldren, p. 193-225, p. 203-325, Cambridge University Press, 1999.

## Revendications

1. Procédé de réalisation d'un multicouche sur un substrat de réception, ledit procédé comprenant les étapes suivantes :
- formation d'un substrat initial (1 ;21 ;51) comportant une couche d'un premier matériau (2 ;22 ;52) formée sur la face d'un substrat support en un deuxième matériau (3 ;23 ;53), le premier matériau ayant une température d'évaporation supérieure à la température d'évaporation du deuxième matériau,
- collage par adhésion moléculaire de la face du substrat initial (1 ;21 ;51) comportant la couche de premier matériau (2 ;22 ;52) sur la face de collage d'un substrat de réception (8 ;28 ;58) pour obtenir une structure collée,
- élimination partielle du substrat initial (1 ;21 ;51) de manière à laisser une couche mince dudit deuxième matériau (3a ;23a ;53a) sur la couche de premier matériau (2 ;22 ;52),
- évaporation de la couche mince de deuxième matériau (3a ;23a ;53a) avec arrêt sélectif sur la couche de premier matériau (2 ;22 ;52), l'évaporation étant effectuée à une température supérieure ou égale à la température d'évaporation du deuxième matériau, et inférieure à la température d'évaporation du premier matériau,
- croissance d'au moins une couche (10, 11) à partir de la couche de premier matériau (2 ;22 ;52) collée sur le substrat de réception (8 ;28 ;58),
l'étape d'évaporation et l'étape de croissance étant réalisées dans un même bâti technologique.

2. Procédé de réalisation d'un multicouche selon la revendication 1, **caractérisé en ce que** le substrat support en deuxième matériau (3 ;23 ;53) est un substrat de deuxième matériau ou une couche de deuxième matériau formée sur un substrat déterminé (25).

3. Procédé de réalisation d'un multicouche selon la revendication 1 ou 2, **caractérisé en ce qu'**il comprend en outre, avant l'étape de collage, une étape de formation d'au moins une couche supplémentaire (4 ;24 ;54) sur la couche de premier matériau (2 ;22 ;52).

4. Procédé de réalisation d'un multicouche selon l'une quelconque des revendications 1 à 3, **caractérisé en ce que** le substrat de réception (8 ;28 ;58) comporte en outre au moins une couche (9 ;29 ;59) sur sa face de collage.

5. Procédé de réalisation d'un multicouche selon l'une quelconque des revendications 1 à 4, **caractérisé en ce que** la face du substrat support en deuxième matériau (3 ;23 ;53) comportant la couche de premier matériau (2 ;22 ;52) et/ou la face de collage du substrat de réception (8 ;28 ;58) comporte (nt) en outre un miroir de Bragg (40 ;60) constitué d'une alternance de couches minces d'indice de réfraction n₁ et d'indice de réfraction n₂ différents.

6. Procédé de réalisation d'un multicouche selon la revendication 1, **caractérisé en ce que** l'étape d'élimination partielle du substrat initial (1 ;21 ;51) est réalisée en effectuant, préalablement à l'étape de collage, une implantation (12) d'espèces gazeuses dans le substrat support de deuxième matériau (3 ;23 ;53), et en effectuant un recuit thermique de la structure implantée collée obtenue, à une température inférieure à la température d'évaporation du deuxième matériau et/ou en appliquant des contraintes mécaniques à la structure implantée collée.

7. Procédé de réalisation d'un multicouche selon la revendication précédente, **caractérisé en ce que** les espèces gazeuses sont choisies parmi H, He, gaz rares...

8. Procédé de réalisation d'un multicouche selon la revendication 1, **caractérisé en ce que** l'étape d'élimination partielle du substrat initial (1 ;21 ;51) est réalisée par un amincissement mécano-chimique dudit substrat initial jusqu'à obtenir une couche mince de deuxième matériau (3a ;23a ;53a) sur la couche de premier matériau (2 ;22 ;52).

9. Procédé de réalisation d'un multicouche selon la revendication 1, **caractérisé en ce que** l'étape de croissance de ladite au moins une couche (10, 11) sur la couche de premier matériau (2 ;22 ;52) est réalisée par épitaxie par jets moléculaires (« MBE » en anglais) ou par dépôt en phase vapeur de composés précurseurs organométalliques (« MOCVD » en anglais), ou par dépôt PECVD.

10. Procédé de réalisation d'un multicouche selon la revendication 1, **caractérisé en ce que** le premier matériau est en AlAs, Si...

11. Procédé de réalisation d'un multicouche selon la revendication 1, **caractérisé en ce que** le deuxième matériau est en GaAs, SiₓGe₁₋ₓ, InP, Ge...

12. Procédé de réalisation d'un multicouche selon la revendication 1, **caractérisé en ce que** le substrat de réception (8 ;28 ;58) est en un matériau choisi parmi le silicium, le verre et la céramique.

13. Procédé de réalisation d'un multicouche selon la revendication 1, **caractérisé en ce que** la au moins une couche (10, 11) formée sur la couche de premier matériau (2 ;22 ;52) collée est en un matériau choisi parmi GaAs, AlAs, Si, SiGe, SiO₂.

14. Structure à cavité résonante comprenant une couche active, qui émet ou qui détecte de la lumière, intercalée entre deux miroirs réfléchissants, ladite structure étant réalisée à partir du procédé de réalisation selon l'une quelconque des revendications 1 à 13.

15. Structure à cavité résonante selon la revendication précédente, **caractérisée en ce que** les deux miroirs réfléchissants sont des miroirs de Bragg (40 ;60) obtenus à partir de couches minces dont les matériaux sont choisis parmi Si₃N₄, SiO₂, TiO₂, Si ou HfO₂.
